# EUROPEAN PATENT SPECIFICATION

(11) **EP 0 457 496 B1**
(45) Date of publication and mention of the grant of the patent: **03.12.1997**
(21) Application number: 91304166.1
(22) Date of filing: 09.05.1991
(51) Int. Cl.: H03M 1/82

(54) **Digital-to-analogue converter with ROM generated pulse width signal**
Digital-Analog-Wandler mit durch ROM erzeugtem Pulsweitensignal
Convertisseur numérique-analogique avec modulation de largeur d'impulsion générée par ROM

(30) Priority: 16.05.1990 JP 125856/90
(43) Date of publication of application: 21.11.1991
(73) Proprietor: SONY CORPORATION, Tokyo 141 (JP)
(72) Inventor: Masuda, Toshihiko, Shinagawa-ku Tokyo 141 (JP); Ueki, Masaaki, Shinagawa-ku Tokyo 141 (JP)
(74) Representative: Cotter, Ivan John

(56) References cited:
- EP-A- 0 141 386

## Description

This invention relates to digital-to-analogue (D/A) converters.

In digital audio disc players, a D/A converter of a pulse amplitude modulation (PAM) system, or a stepped-wave system, in which input digital data are converted to PAM signals and finally to an analogue signal has been widely used.

Recently, a D/A converter of a pulse width modulation (PWM) system in which input digital data are converted to PWM signals and finally to an analogue signal has come to be used.

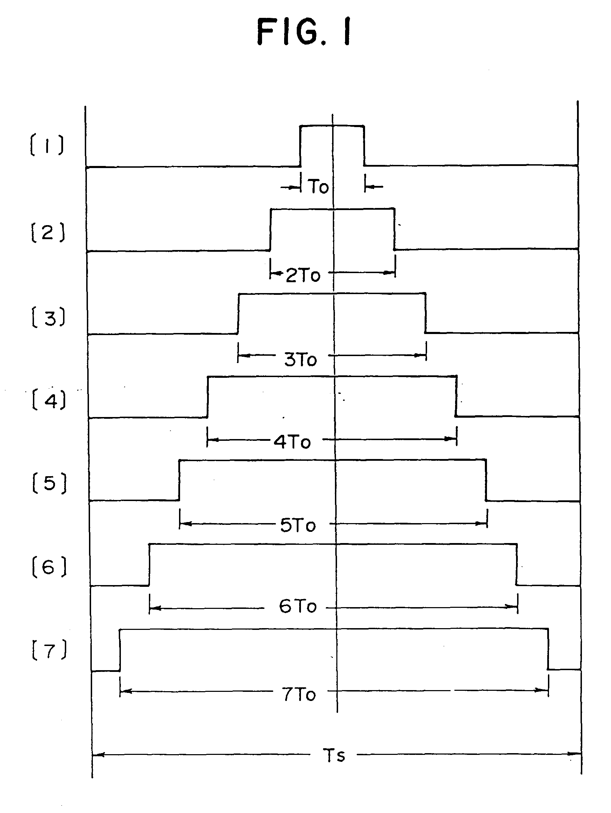

In this case, in order to reduce quantization noise within the audio frequency domain, and to obtain the necessary resolution, an over-sampling method and a noise shaping method, disclosed, for example, in Japanese Laid-open Patent Specification 61/177819, are used in combination and, thereby, 3-bit 7-value digital data D1 and D7 and PWM signals whose pulse widths are TO to 7TO corresponding to the values [1] to [7] of the digital data as shown in Figure 1 are generated.

The D/A converter of the PAM system has, due to the principle upon which it is based, a good linearity and provides a converted analogue output signal with small distortion. However, it requires high precision current adders functioning accurately corresponding to weights of the bits of input digital data, and an electronic switch operating with accurate timing. Hence, there have been difficulties that the circuit becomes larger if its resolution is to be increased, and, in addition, the overall circuit must be structured with high precision.

Although the known D/A converter has the merit that its circuit configuration is simple, there is the problem that it generates even harmonic distortion, thereby to degrade the analogue signal.

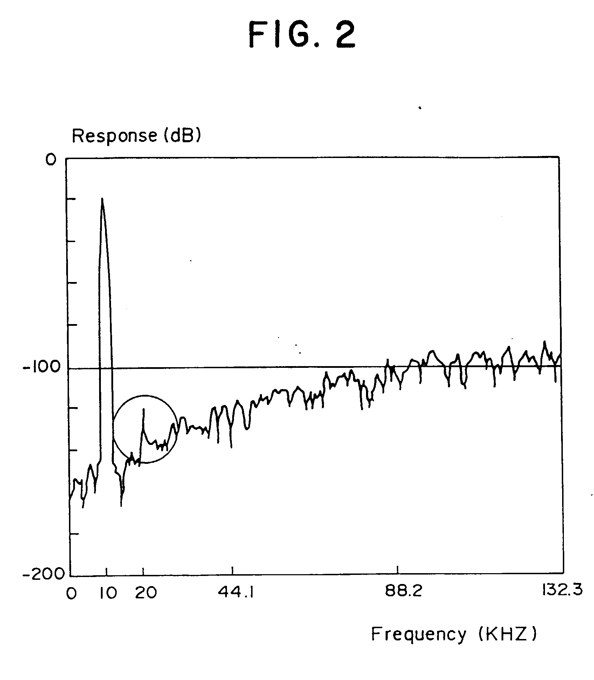

Such distortion is substantial when the signal frequency is high or the pulse rate is low. For example, as shown in Figure 2, with respect to the fundamental wave at 10 kHz, relatively large distortion appears especially in the second harmonic domain.

To overcome these difficulties, we have already proposed a D/A converter of a PWM system, in which a differential component between a PWM waveform corresponding to the input digital data and a complementary PWM waveform corresponding to 2s-complement data of the input digital data is derived by a differential amplifier, and the high-frequency component of the differential output waveform is eliminated thereby to obtain the analogue output signal with its harmonic distortion reduced (US patent application 479,163, filed 13 February 1990).

This D/A converter, however, necessarily requires two PWM circuits, because it generates a pair of complementary PWM signals.

European Patent Application Publication No. EP-A-O 141 386 discloses a digital-to-analogue converting system for converting input serial digital data into an analogue signal. The system comprises a serial to parallel converter for converting the serial input data into parallel form. The higher order bits and the lower order bits of the parallel converted data are converted by PAM and PWM control sections, respectively, to provide PAM and PWM control signals. The two control signals are added in timed relationship to each other by applying them to switches that control constant current generators that are connected to an inverting input of a differential amplifier whose non-inverting input is grounded. The differential amplifier produces pulses which are converted through interpolation by a low pass filter. The PWM control circuit may be operative such that two different PWM waves of different pulse width variations and with pulse widths varying symmetrically with respect to respective timings according to the lower order bit data are provided once in each conversion period, one wave in a first part of the conversion period and the other wave in a second part of the conversion period.

Respective different aspects of the invention are set forth in claims 1 and 3 hereof.

An embodiment of the present invention described below provides a digital-to-analogue converter comprising a pulse-width modulated signal generation means for generating a pulse-width modulated signal with a pulse width corresponding to input digital data, and a low-pass filter means for eliminating high-frequency components of the pulse-width modulated signal thereby to output an analogue signal, wherein the sampling period Ts of the input digital data is divided by an even number 2m, and the pulse-width modulated signal generation means generates pulse-width modulated signals with equal pulse widths n ^{.} Tu corresponding to the input digital data such that each signal is generated in each of the divided sampling period Ts/2m.

With embodiments of the present invention, harmonic distortion can be reduced, and high a quality analogue signal obtained with a simple structure.

The invention will now be described by way of example with reference to the accompanying drawings, throughout which like parts are referred to by like references, and in which:
Figure 1 is a waveform chart for explaining the operation of a previously proposed D/A converter;
Figure 2 is a spectrum diagram;
Figure 3 is a block diagram of an embodiment of D/A converter according to the present invention;
Figure 4 is a waveform chart for explaining the operation of the embodiment;
Figure 5 is a spectrum diagram; and
Figure 6 is a block diagram showing another embodiment of the present invention.

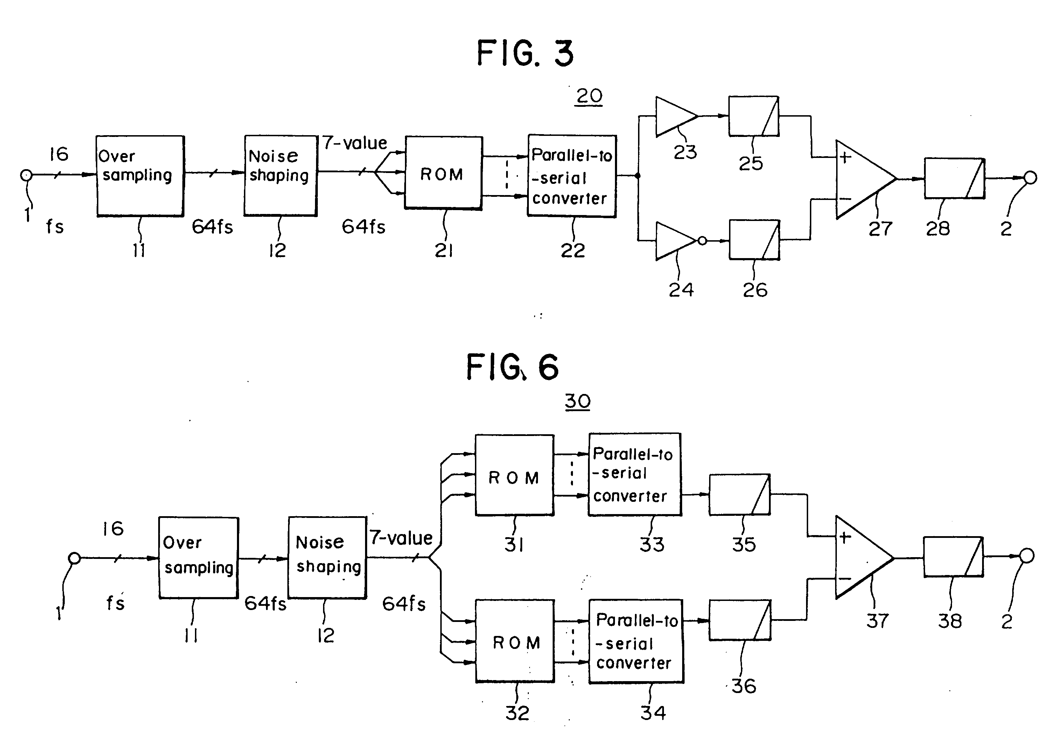

The embodiment of Figure 3 comprises an over-sampling circuit 11, which receives, through an input terminal 1, 16-bit reproduced digital audio data the sampling frequency fs of which is 44.1 kHz, and performs an over-sampling process for converting the received data to digital data whose sampling frequency is 64 · fs.

A noise shaping circuit 12 performs a noise shaping process for rounding the 16-bit digital data output from the over-sampling circuit 11 into, for example, 3-bit 7-value digital data thereby reducing the quantization noise.

A PWM circuit is formed, in the present embodiment, of a read-only memory (ROM) 21 and a parallel-to-serial converter 22. The output data from the noise shaping circuit 12 are supplied as read addresses to the ROM 21, and parallel data read out of the ROM 21 are converted into serial data in the parallel-to-serial converter 22.

The serial data are commonly supplied to a buffer 23 and an inverter 24, and the outputs of the buffer 23 and the inverter 24 are respectively supplied to the non-inverting input terminal and the inverting input terminal of a differential amplifier 27 through low-pass filters 25 and 26 for suitably limiting the slew rate. The output of the differential amplifier 27 has its level brought to twice as high as that of one of the input signals, to remove common mode noise. This output is led to an output terminal 2 through a low-pass filter 28.

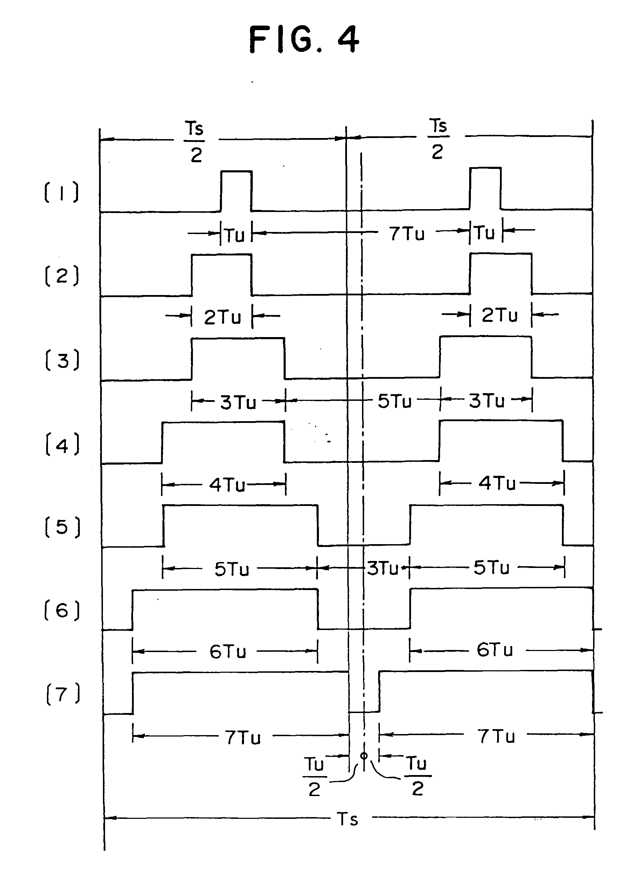

The operation will now be described with reference to Figure 4.

In this embodiment, parallel data as shown in the following Table 1 are written in the ROM 21 in advance.

**Table 1**

| Address | Parallel Data | | | | | | | | | | | | | | | |
|---|---|---|---|---|---|---|---|---|---|---|---|---|---|---|---|---|
| 1 | 0 | 0 | 0 | 0 | 1 | 0 | 0 | 0 | 0 | 0 | 0 | 0 | 1 | 0 | 0 | 0 |
| 2 | 0 | 0 | 0 | 1 | 1 | 0 | 0 | 0 | 0 | 0 | 0 | 0 | 1 | 1 | 0 | 0 |
| 3 | 0 | 0 | 0 | 1 | 1 | 1 | 0 | 0 | 0 | 0 | 0 | 1 | 1 | 1 | 0 | 0 |
| 4 | 0 | 0 | 1 | 1 | 1 | 1 | 0 | 0 | 0 | 0 | 0 | 1 | 1 | 1 | 1 | 0 |
| 5 | 0 | 0 | 1 | 1 | 1 | 1 | 1 | 0 | 0 | 0 | 1 | 1 | 1 | 1 | 1 | 0 |
| 6 | 0 | 1 | 1 | 1 | 1 | 1 | 1 | 0 | 0 | 0 | 1 | 1 | 1 | 1 | 1 | 1 |
| 7 | 0 | 1 | 1 | 1 | 1 | 1 | 1 | 1 | 0 | 1 | 1 | 1 | 1 | 1 | 1 | 1 |

An address in the ROM 21 is selected according to the input data supplied from the noise shaping circuit 12, and thus, a set of parallel data is read out from the ROM 21 according to the value of the input data. The parallel data read out of the ROM 21 are converted into a set of series data in the parallel-to-serial converter 22, and thereby a PWM signal as shown in Figure 4 is generated.

As understood from Figure 4, each of the odd-numbered PWM signals has the same PWM signal waveforms with a pulse width n · Tu (Tu is the unit pulse width) corresponding to the input data value [n], repeated in the first half and the second half of the sampling period Ts. As to the even-numbered signals, although each signal has the same PWM signal waveform with a pulse width corresponding to the input data value, that in the second half is shifted backward by the unit pulse width Tu.

Therefore, in the middle of each even-numbered PWM signal, there is formed a low level portion at the same timing as that of the immediately preceding odd-numbered PWM signal. Thus, the waveforms of each signal are symmetrically divided about the centre of the low level portion, which centre is located backwardly of the centre of the sampling period Ts by Tu/2.

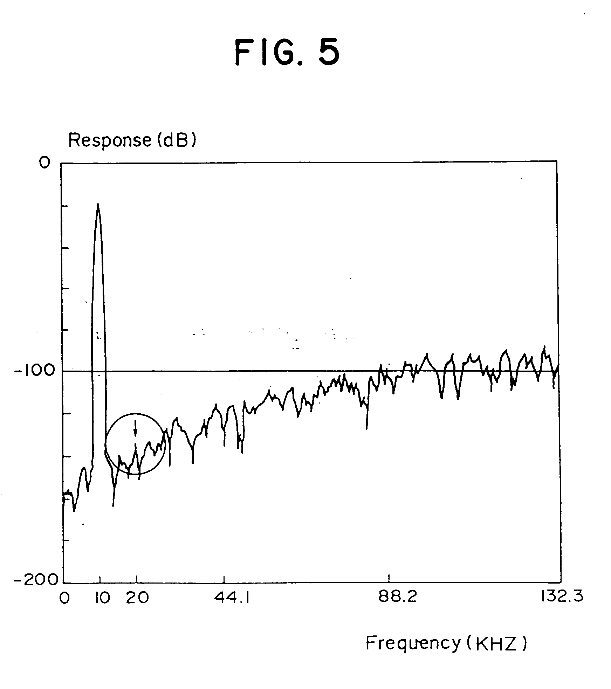

Further, in the first half and the second half of each of the PWM signals, there are preserved the information of the input data in the form of equal pulse widths. Therefore, even if the clock frequency is fixed, the pulse rate becomes higher in effect and, accordingly, the second harmonic distortion can be greatly reduced as shown in Figure 5, and a high quality analogue signal can be obtained.

Even if the PWM signals are such that are obtained by exchanging the waveforms of Figure 4 between left and right, effects completely the same as above can be obtained.

With the embodiment described above, the pulse rate can be increased while using a simple structure. Therefore, it can be advantageously applied to integrated circuits when the clock frequency is close to the operational upper limit.

Although, in the above embodiment, the case where the waveform of the PWM signal is divided into two waveforms was described, the waveform can be divided into another even number by arranging that the PWM signals as shown in Figure 4 are repeatedly read out a plurality of (m) of times, while the time base is compressed to the reciprocal of the number of read times.

Another embodiment will now be described with reference to Figure 6.

This embodiment comprises PWM circuits 30, each of which in the present embodiment is formed of a ROM 31, 32 and a parallel-to-serial converter 33, 34. One ROM 31 stores the parallel data as shown in Table 1 written therein in advance, and the other ROM 32 stores inverted parallel data obtained by exchanging "1" and "0" in Table 1 with each other, written therein in advance. The outputs of the parallel-to-serial converters 33 and 34 are respectively supplied to the non-inverting input terminal and the inverting input terminal of a differential amplifier 37 through low-pass filters 35 and 36, and the output of the differential amplifier 37 is led out to an output terminal 2 through a low-pass filter 38. Otherwise, the structure is the same as that of Figure 3.

The embodiment of Figure 6 operates the same as the above described embodiment and provides the same effects and, further, has the advantage that it can be easily modified to accommodate various changes in the specification.

## Claims

1. A digital-to-analogue converter for converting input digital data into an analogue signal, the converter comprising:
pulse-width modulated signal generation means (20) for generating a pulse-width modulated signal with a pulse width corresponding to said input digital data (D1 to D7); and
a low pass filter (28) for eliminating high-frequency components of said pulse-width modulated signal thereby to output said analogue signal;
wherein said pulse-width modulated signal generation means (20) divides the sampling period of said input digital data into a number m (= 2, 3, ...) of sampling periods and generates a pulse-width modulated signal with two equal pulse widths corresponding to said input digital data in each divided sampling period;
wherein said signal having two pulse widths is symmetrical about a point at some distance from the centre of said divided sampling period; and
wherein said pulse-width modulated signal generation means (20) comprises ROM means (21) accepting input digital data as address data for outputting parallel data, and a parallel-to-serial converter (22) for converting said parallel data to serial data corresponding to said signal with two pulse widths.

2. A converter according to claim 1, wherein said pulse-width modulated signal generation means (20) further comprises a buffer (23) and an inverter (24) arranged in parallel and commonly connected to the output of said parallel-to-serial converter (22), and a differential amplifier (27) whose non-inverting input and inverting input are respectively connected to the output of said buffer (23) and the output of said inverter (24), wherein the output of said differential amplifier (27) is supplied to said low-pass filter (28).

3. A converter for converting input digital data into an analogue signal, the converter comprising:
pulse-width modulated signal generation means (20) for generating a pulse-width modulated signal with a pulse width corresponding to said input digital data (D1 to D7); and
a low pass filter (28) for eliminating high-frequency components of said pulse-width modulated signal thereby to output said analogue signal;
wherein said pulse-width modulated signal generation means (20) divides the sampling period of said input digital data into a number m (= 2, 3, ...) of sampling periods and generates a pulse-width modulated signal with two equal pulse widths corresponding to said input digital data in each divided sampling period;
wherein said signal having two pulse widths is symmetrical about a point at some distance from the centre of said divided sampling period; and
wherein said pulse-width modulated signal generation means (20) comprises first ROM means (31) accepting input digital data as address data for outputting first parallel data, second ROM means (32) accepting input digital data as address data for outputting inverted data of said first parallel data as second parallel data, a first parallel-to-serial converter (33) for converting said first parallel data to serial data corresponding to said signal with two pulse widths, a second parallel-to-serial converter (34) for converting said second parallel data to serial data corresponding to said signal with two pulse widths, and a differential amplifier (37) whose non-inverting input and inverting input are respectively connected with the output of said first parallel-to-serial converter (33) and the output of said second parallel-to-serial converter (34), wherein the output of said differential amplifier (37) is supplied to said low-pass filter (38).

## Patentansprüche

1. Digital-Analog-Wandler zur Umwandlung von digitalen Eingangsdaten in ein analoges Signal
mit einer Einrichtung (20) zur Erzeugung eines pulsbreitenmodulierten Signals mit einer Impulsbreite, die den digitalen Eingangsdaten (D1 bis D7) entspricht,
und mit einem Tiefpaßfilter (28) zum Eliminieren hochfrequenter Komponenten des pulsbreitenmodulierten Signals und zur Ausgabe des analogen Signals,
wobei die Einrichtung (20) zur Erzeugung des pulsbreitenmodulierten Signals die Abtastperiode der digitalen Eingangsdaten in eine Anzahl m (= 2, 3, ...) von Abtastperioden unterteilt und ein pulsbreitenmoduliertes Signal mit zwei gleichen Impulsbreiten erzeugt, die in jeder der unterteilten Abtastperioden den digitalen Eingangsdaten entsprechen,
wobei das Signal mit den beiden Impulsbreiten symmetrisch um einen Punkt angeordnet ist, der sich in einigem Abstand vom Zentrum der unterteilten Abtastperiode befindet,
und wobei die Einrichtung (20) zur Erzeugung des pulsbreitenmodulierten Signals einen Nurlesespeicher (21) aufweist, der digitale Eingangsdaten als Adressendaten aufnimmt, um parallele Daten auszugeben, sowie einen Parallel-Serien-Wandler (22) zum Umwandeln der parallelen Daten in serielle Daten, die dem genannten Signal mit zwei Impulsbreiten entsprechen.

2. Wandler nach Anspruch 1, bei dem die Einrichtung (20) zur Erzeugung des pulsbreitenmodulierten Signals außerdem einen Puffer (23) und einen Inverter (24) aufweist, die parallel angeordnet und gemeinsam mit dem Ausgang des Parallel-Serien-Wandlers (22) verbunden sind, sowie einen Differenzverstärker (27), dessen nichtinvertierender Eingang und invertierender Eingang mit dem Ausgang des Puffers (23) bzw. mit dem Ausgang des Inverters (24) verbunden sind, wobei das Ausgangssignal des Differenzverstärkers (27) dem Tiefpaßfilter (28) zugeführt wird.

3. Wandler zur Umwandlung von digitalen Eingangsdaten in ein analoges Signal
mit einer Einrichtung (20) zur Erzeugung eines pulsbreitenmodulierten Signals mit einer Impulsbreite, die den digitalen Eingangsdaten (D1 bis D7) entspricht,
und mit einem Tiefpaßfilter (28) zum Eliminieren hochfrequenter Komponenten des pulsbreitenmodulierten Signals und zur Ausgabe des analogen Signals,
wobei die Einrichtung (20) zur Erzeugung des pulsbreitenmodulierten Signals die Abtastperiode des digitalen Eingangsdaten in einer Anzahl m (= 2, 3, ...) von Abtastperioden unterteilt und ein pulsbreitenmoduliertes Signal mit zwei gleichen Impulsbreiten erzeugt, die in jeder der unterteilten Abtastperioden den digitalen Eingangsdaten entsprechen,
wobei das Signal mit den beiden Impulsbreiten symmetrisch um einen Punkt angeordnet ist, der sich in einigem Abstand vom Zentrum der unterteilten Abtastperiode befindet,
und wobei die Einrichtung (20) zur Erzeugung des pulsbreitenmodulierten Signals einen ersten Nurlesespeicher (31) aufweist, der digitale Eingangsdaten als Adressendaten aufnimmt, um erste parallele Daten auszugeben, einen zweiten Nurlesespeicher (32), der digitale Eingangsdaten als Adressendaten aufnimmt, um gegenüber den ersten parallelen Daten invertierte Daten als zweite parallele Daten auszugeben, einen ersten Parallel-Serien-Wandler (33) zum Umwandeln der ersten parallelen Daten in serielle Daten, die dem genannten Signal mit zwei Impulsbreiten entsprechen, einen zweiten Parallel-Serien-Wandler (34) zum Umwandeln der zweiten parallelen Daten in serielle Daten, die dem genannten Signal mit zwei Impulsbreiten entsprechen, und einen Differenzverstärker (37), dessen nichtinvertierender Eingang und invertierender Eingang mit dem Ausgang des ersten Parallel-Serien-Wandlers (33) bzw. mit dem Ausgang des zweiten Parallel-Serien-Wandler (34) verbunden sind, wobei das Ausgangssignals des Differenzverstärkers (37) dem Tiefpaßfilter (38) zugeführt wird.

## Revendications

1. Convertisseur de numérique en analogique destiné à convertir une donnée numérique d'entrée en un signal analogique, le convertisseur comprenant :
un moyen (20) générateur de signal modulé en largeur d'impulsion for produire un signal modulé en largeur d'impulsion avec une largeur d'impulsion correspondant à ladite donnée numérique d'entrée (D1 à D7) ; et
un filtre passe-bas (28) destiné à éliminer les composantes à haute fréquence dudit signal modulé en largeur d'impulsion pour sortir ainsi ledit signal analogique ;
dans lequel ledit moyen (20) générateur de signal modulé en largeur d'impulsion divise la période d'échantillonnage de ladite donnée numérique d'entrée en un certain nombre m (= 2, 3, ... ) de périodes d'échantillonnage et produit un signal modulé en largeur d'impulsion avec deux largeurs d'impulsion égales correspondant à ladite donnée numérique d'entrée dans chaque période d'échantillonnage élémentaire ;
dans lequel ledit signal ayant deux largeurs d'impulsion est symétrique par rapport à un point situé à une certaine distance du centre de ladite période d'échantillonnage élémentaire ; et
dans lequel ledit moyen (20) générateur de signal modulé en largeur d'impulsion comprises un moyen formant ROM (mémoire morte) (21) acceptant la donnée numérique d'entrée comme donnée d'adresse pour sortir une donnée parallèle, et un convertisseur de parallèle en série (22) pour convertir ladite donnée parallèle en donnée sérielle correspondant audit signal avec deux largeurs d'impulsion.

2. Convertisseur selon revendication 1, dans lequel ledit moyen (20) générateur de signal modulé en largeur d'impulsion comprend en outre une mémoire tampon (23) et un inverseur (24) agencés en parallèle et connectés en commun à la sortie dudit convertisseur de parallèle en série (22), et un amplificateur différentiel (27) dont l'entrée non inversante et l'entrée inversante sont, respectivement, connectées à la sortie de ladite mémoire tampon (23) et à la sortie dudit inverseur (24), la sortie dudit amplificateur différentiel (27) étant délivrée audit filtre passe-bas (28).

3. Convertisseur destiné à convertir une donnée numérique d'entrée en un signal analogique, le convertisseur comprenant :
un moyen (20) générateur de signal modulé en largeur d'impulsion for produire un signal modulé en largeur d'impulsion avec une largeur d'impulsion correspondant à ladite donnée numérique d'entrée (D1 à D7) ; et
un filtre passe-bas (28) destiné à éliminer les composantes à haute fréquence dudit signal modulé en largeur d'impulsion pour sortir ainsi ledit signal analogique ;
dans lequel ledit moyen (20) générateur de signal modulé en largeur d'impulsion divise la période d'échantillonnage de ladite donnée numérique d'entrée en un certain nombre m (= 2, 3, ... ) de périodes d'échantillonnage et produit un signal modulé en largeur d'impulsion avec deux largeurs d'impulsion égales correspondant à ladite donnée numérique d'entrée dans chaque période d'échantillonnage élémentaire ;
dans lequel ledit signal ayant deux largeurs d'impulsion est symétrique par rapport à un point situé à une certaine distance du centre de ladite période d'échantillonnage élémentaire ; et
dans lequel ledit moyen (20) générateur de signal modulé en largeur d'impulsion comprises un premier moyen formant ROM (31) acceptant la donnée numérique d'entrée comme donnée d'adresse pour sortir une donnée parallèle, un second moyen formant ROM (32) acceptant la donnée numérique d'entrée comme donnée d'adresse pour sortir une donnée inversée de ladite première donnée parallèle comme seconde donnée parallèle, un premier convertisseur de parallèle en série (33) pour convertir ladite première donnée parallèle en donnée sérielle correspondant audit signal avec deux largeurs d'impulsion, un second convertisseur de parallèle en série (34) pour convertir ladite seconde donnée parallèle en donnée sérielle correspondant audit signal avec deux largeurs d'impulsion, et un amplificateur différentiel (37) dont l'entrée non inversante et l'entrée inversante sont, respectivement, connectées à la sortie dudit premier convertisseur de parallèle en série (33) et à la sortie dudit second convertisseur de parallèle en série (34), la sortie dudit amplificateur différentiel (37) étant délivrée audit filtre passe-bas (38).
